# EUROPEAN PATENT APPLICATION

(11) **EP 4 417 991 A1**
(43) Date of publication of application: **21.08.2024**
(21) Application number: 23157065.6
(22) Date of filing: 16.02.2023
(51) Int. Cl.: G01R 33/36

(54) **RADIO FREQUENCY TRANSMISSION LINE ARRANGEMENT**

(71) Applicant: Koninklijke Philips N.V., 5656 AG Eindhoven (NL)
(72) Inventor: FINDEKLEE, Christian, Eindhoven (NL); LEUSSLER, Christoph Günther, Eindhoven (NL); VERNICKEL, Peter, 5656 AG Eindhoven (NL)
(74) Representative: Philips Intellectual Property & Standards

(57) **Abstract**

According to the invention, a radio frequency transmission line arrangement (1) for a magnetic resonance imaging device, comprising a first symmetrical transmission line (2) having a first characteristic impedance and a further symmetrical transmission line (4) having a further characteristic impedance, wherein
the first symmetrical transmission line (2) and the further symmetrical transmission line (4) each comprise a first wire (6) and a second wire (8),
the first wire (6) of the first symmetrical transmission line (2) is galvanically connected in parallel to the first wire (6) of the further symmetrical transmission line (4) and
the second wire (8) of the first symmetrical transmission line (2) is galvanically connected in parallel to the second wire (8) of the further symmetrical transmission line (4) such
that the total characteristic impedance of the radio frequency transmission line arrangement (1) resulting from the first symmetrical transmission line (2) and the further symmetrical transmission line (4) is reduced compared to the first characteristic impedance and the further characteristic impedance, respectively.

In this way, a symmetrical radio frequency transmission line (1) having a characteristic impedance suitable for the transmission of radio frequency signals in magnetic resonance imaging system (31) is provided.

## Description

### FIELD OF THE INVENTION

The invention relates to the field of magnetic resonance imaging. In particular, the present invention relates to the field of radio frequency transmission in a magnetic resonance imaging device.

### BACKGROUND OF THE INVENTION

A part of every magnetic resonance imaging device is the radio frequency antenna system for receiving and converting the magnetic resonance signal. The radio frequency antenna system comprises a radio frequency coil, a matching network, a preamplifier and an analog-to-digital converter. In magnetic resonance imaging a system integrated body coil generates the excitation magnetic field for the spin system causing a preceding relaxation. The precession of the net magnetization induces a current in the radio frequency coil via electromagnetic induction. The radio frequency coil generally comprises a conducting wire with an inductance and a coil resistance. Like any radio frequency operated system, the radio frequency antenna system is subject to noise. Thereby an important requirement is to achieve a minimum noise figure. The lowest noise figure is achieved when the source characteristic impedance is matched to the noise characteristic impedance of the amplification circuit and interference in the high frequency transmission lines carrying the high frequency signal is reduced, as these interferences affect the transmitted radio frequency signal.

These interferences can be generated by external radiation, the magnetic induction induced by the magnetic resonance imaging device and the excitation frequency corresponding to the Larmor frequency. These interferences are common mode signals. There are two different modes of signal transmission: differential mode and common mode. The differential mode signal can be carried by currents in the two conductors with the same amplitude but 180° phase difference.

Common mode signals refer to interference voltages and currents on the connecting lines between electrical components, which propagate with the same phase position and current direction in both conductors between these components.

It is demanded to avoid these common mode signals or common mode currents, especially during radio frequency signal transmission, since otherwise high currents become a safetyrelevant issue. During reception, efficient reduction of the common mode signals of the signal transmission lines is very important to get all the signal coupled into the receivers and to avoid oscillations. In case of using symmetric inputs at the receivers, this is even more challenging due to the additional pin, that is the local ground pin, at the input and the potential unsymmetric coupling to the ground.

Symmetric structures like standard RF-SoCs or customized digital receivers need therefore efficient common mode signal reduction of symmetrical transmission lines.

Since typical radio frequency transmission lines are optimized for low signal losses, they mostly use characteristic impedances of 50 Ω or 75 Ω. Most components are matched to 50 Ω as industrial standard.

However, symmetrical transmission lines are typically using two equal conductors with or without additional shielding. These transmission lines typically have a characteristic impedance of 100 Ω and can therefore not be used directly for radio frequency signal transmission in magnetic resonance devices.

From WO 2006/103591 A1 a magnetic resonance imaging system is known wherein, in order to reduce the number of cablings, the system comprises: an examination zone arranged to receive a body for examination; magnetic field generating means for generating a magnetic field in the examination zone; a receiving unit located in the examination zone or in the vicinity of the examination zone; an interface unit located in the examination zone or in the vicinity of the examination zone, and arranged separately from the receiving unit; and a signal processing unit disposed at a location remote from the receiving unit and the interface unit; wherein the receiving unit comprising a receiver adapted to receive a spin resonance signal generated in the examination zone, and a transmitter adapted to transmit the spin resonance signal to the interface unit; and wherein the interface unit comprises a receiver for receiving the spin resonance signals, an analog to digital converter adapted to generate a digital signal in response to the received spin resonance signal, and a transmitter for transmitting the digitized signal to the signal processing unit.

Further, US 2010/0072997 A1 describes a magnetic resonance system with a patient receptacle and a base body. The patient receptacle comprises a subframe and a patient bed supported thereon so as to move a patient thereon through the base body. The base body has a basic field magnet system, a gradient system and an RF system that are operable to obtain an analog magnetic resonance signal from the patient. The patient receptacle has a signal conversion device composed of an A/D converter, a modulator and a transmitter. The base body has a signal conversion device composed of a receiver and a demodulator. The A/D converter receives the magnetic resonance signal and digitizes it. The modulator modulates a carrier signal with the digitized magnetic resonance signal. The transmitter transmits the modulated carrier signal via an air gap to the receive. The receiver receives the transmitted carrier signal. The demodulator extracts the digitized magnetic resonance signal from the received carrier signal by demodulation and supplies it to an evaluation device for continuing evaluation.

### SUMMARY OF THE INVENTION

It is the object of the invention to provide a radio frequency transmission line arrangement having a characteristic impedance which is particular suitable for the transmission of radio frequency signals in magnetic resonance imaging.

According to the invention, this object is addressed by the subject matter of the independent claims. Preferred embodiments of the invention are described in the dependent claims.

Therefore, according to the invention, a radio frequency transmission line arrangement for a magnetic resonance imaging device is provided, comprising a first symmetrical transmission line having a first characteristic impedance and at least one further symmetrical transmission line having a further characteristic impedance, wherein
the first symmetrical transmission line and the further symmetrical transmission line each comprise a first wire and a second wire,
the first wire of the first symmetrical transmission line is galvanically connected in parallel to the first wire of the further symmetrical transmission line and
the second wire of the first symmetrical transmission line is galvanically connected in parallel to the second wire of the further symmetrical transmission line such
that the total characteristic impedance of the radio frequency transmission line arrangement resulting from the first symmetrical transmission line and the further symmetrical transmission line is reduced compared to the first characteristic impedance and the further characteristic impedance, respectively.

According to the invention, one single further symmetrical transmission line or multiple further symmetrical transmission lines may be provided.

By employing symmetrical transmission lines in parallel, the resulting characteristic impedance is reduced and can be matched to the impedance of a radio frequency coil or a noise-optimal impedance of a preamplifier impedance. The objective is to achieve a minimum noise figure, which is defined as the ratio of an input signal-to-noise ratio to an output signal-to-noise ratio with respect to a preamplifier or a receiver.

It is possible to arrange the first symmetrical transmission line and the second symmetrical transmission line in different ways. According to a preferred embodiment of the invention, the lines run parallel to each other. According to another preferred embodiment of the invention, the first wire of the first symmetrical transmission line and the second wire of the first symmetrical transmission line are twisted with each other, and the first wire of the further symmetrical transmission line and the second wire of the further symmetrical transmission line are twisted with each other. By twisting the wires, interference factors have an almost identical influence on both the first wire and the second wire of the respective symmetrical transmission line as corresponding sections in the first and second wires see the same spatial angle.

According to a preferred embodiment of the invention the first symmetrical transmission line and the further symmetrical transmission line are wrapped around a body such that a coil is formed. In this way, the magnetic flux can be concentrated in a certain area since. e.g. a toroid keeps the flux almost completely internally which reduces coupling between individual traps or to any other fields. In this respect, the body may be formed from different materials. Preferably, the material of the body is a plastic material.

It is further provided, according to a particularly preferred embodiment of the invention, that the first symmetrical transmission line and the further symmetrical transmission line are wrapped around the body in opposite directions. Wrapping in opposing directions means here that the transmitted signal of the first symmetrical transmission line is transmitted against the direction of the signal of the further symmetrical transmission line.

In general, the body can be shaped in several ways. According to a preferred embodiment of the invention, however, the body is a toroid. In this way, as mentioned above, the magnetic flux is concentrated in the area enclosed by the toroidal body.

According to another preferred embodiment of the invention the body is a solenoid. The number of windings on the body can be used to set the inductance of the coil and thus the characteristic impedance of the same.

In general, the first symmetrical transmission line and the further symmetrical transmission line can be formed in different ways. However, according to a preferred embodiment of the invention, the first symmetrical transmission line and the further symmetrical transmission line are each formed by a twinaxial cable, the first wire and the second wire of the first symmetrical transmission line and the further symmetrical transmission line being formed by the inner conductors of the twinaxial cables, and a ground potential of the radio frequency transmission line arrangement resulting from the first symmetrical transmission line and the further symmetrical transmission line is formed in a first conductive shielding of the first symmetrical transmission line in parallel to a further conductive shielding of the further symmetrical transmission line.

Twinaxial cabling or "Twinax", is a type of cable similar to a coaxial cable, but with two inner conductors instead of one. The first and second inner conductors of the twinaxial cable are each insulated from each other and are also insulated from a conductive shielding surrounding the inner conductors. The conductive shielding which surrounds the first inner conductor, the second inner conductor and the dielectric may have the shape of a hollow cylinder. A galvanically isolated physical protection may surround the conductive shielding. In this way, both the advantages of a symmetric or balanced transmission line and the advantages of an asymmetric or unbalanced transmission line given by the addition of a ground potential in the first symmetrical transmission line and a further ground potential in the further symmetrical transmission line are provided.

A cable trap, also known as wave trap, high-frequency stopper or line trap, is a resonant circuit or arrangement that blocks a certain frequency of an electrical oscillation because the resistance formed for the common mode is particularly high at that certain frequency. Line traps or cable traps are typically employed to block common mode currents.

According to a preferred embodiment, the radio frequency transmission line arrangement further comprises an additional conductive shield around the first symmetrical transmission line and the further symmetrical transmission line. For building the current mode traps, an additional shielding of the symmetrical transmission lines can locally be employed to avoid opening the twinaxial cables for connecting a resonance capacitor of the trap. This additional shielding might also be used for the complete cable and not just at the trap positions.

According to a preferred embodiment of the invention, the first conductive shielding and the further conductive shielding are galvanically connected in parallel to a first capacitor. The shields of the first twinaxial cable and the further twinaxial cable in combination with the galvanically connected capacitor and the inductivity formed by the loop provide for an effective cable trap. This so-called common mode trap blocks out certain common mode currents of frequencies adjustable by the capacitance of the capacitor. In electrical engineering, a common mode trap or a blocking circuit is an arrangement that blocks a certain frequency of an electrical oscillation because its resistance is particularly high at this frequency. In general, by building a loop, an inductance is created with the first conductive shielding and the further conductive shielding. This is then resonated with the first capacitor by connecting this first capacitor in parallel to the loop to the first conductive shielding and the further conductive shielding. The high impedance generated at the resonant frequency again blocks common mode signals.

In this respect, it is further preferred that the first conductive shielding and the further conductive shielding are galvanically connected in parallel to a second capacitor. The additional capacitor allows an even more precise setting of the frequency to be blocked.

The invention further provides a magnetic resonance imaging system with a radio frequency transmission line arrangement as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a radio frequency transmission line arrangement according to a preferred embodiment of the invention,
Fig. 2 schematically depicts a radio frequency transmission line arrangement according to another preferred embodiment of the invention,
Fig. 3a schematically depicts a radio frequency transmission line arrangement wrapped around a toroid according to a preferred embodiment of the invention,
Fig. 3b schematically depicts a radio frequency transmission line arrangement wrapped around a solenoid according to a preferred embodiment of the invention and
Fig. 4 schematically depicts a magnetic resonance imaging system according to a preferred embodiment of the invention.

### DETAILED DESCRIPTION OF EMBODIMENTS

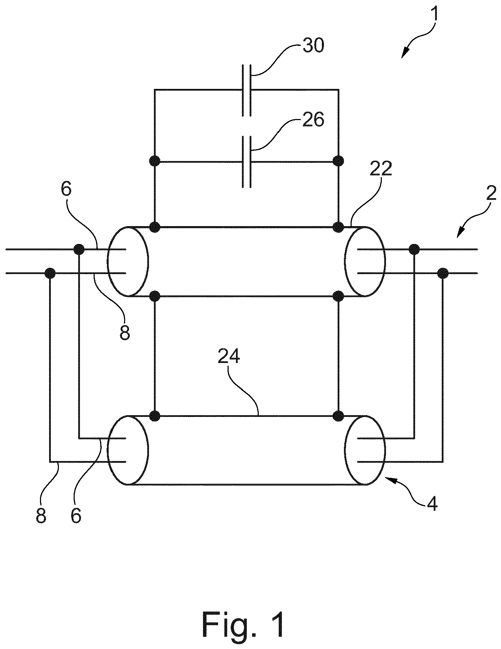

Fig. 1 schematically depicts a radio frequency transmission line arrangement 1 according to a preferred embodiment of the invention. A first symmetrical transmission line 2 is galvanically connected to a further symmetrical transmission line 4. In general, the invention also covers the connection of the first symmetrical transmission line 2 to one or more additional further symmetrical transmission line(s). However, for the sake of clarity, the embodiment described here only comprises a first symmetrical transmission line 2 which is galvanically connected to one single further symmetrical transmission line 4.

The first symmetrical transmission line 2 and the further symmetrical transmission line 4 each comprise a first wire 6 and a second wire 8. The first wire 6 of the first symmetrical transmission line 2 is galvanically connected in parallel to the first wire 6 of the further symmetrical transmission line 4 and the second wire 8 of the first symmetrical transmission line 2 is galvanically connected in parallel to the second wire 8 of the further symmetrical transmission line 4. Hence, the first symmetrical transmission line 2 and the further symmetrical transmission line 4 are each formed by a twinaxial cable, respectively, each having wires 6, 8 as inner conductors, wherein the inner conductors of the two different transmission lines 2, 4 are pairwise connected to each other.

This radio frequency transmission line arrangement 1 which results from the first symmetrical transmission line 2 and the further symmetrical transmission line 4 can be arranged between a radio frequency coil and a preamplifier in a magnetic resonance imaging device for transmitting a radio frequency signal between the radio frequency coil and the preamplifier. Thus, a radio frequency transmission line arrangement 1 is achieved which virtually is a "superior symmetrical transmission line" formed by the first symmetrical transmission line 2 and the further symmetrical transmission line 4 and which has a lower characteristic impedance than the first symmetrical transmission line 2 and the further symmetrical transmission line 4, respectively . The skilled choice of characteristic impedances or the parallel connection of at least one further symmetrical transmission line 4 thus enables the symmetrical transmission of a radio frequency signal via the thus achieved radio frequency transmission line arrangement 1 at a characteristic impedance matching a desired impedance for a connected device directly or via additional matching networks.

Further, the first symmetrical transmission line 2 and the further symmetrical transmission line 4 are provided with a first conductive shielding 22 and a further conductive shielding 24, respectively. The first conductive shielding 22 and a further conductive shielding 24 are connected to each other in parallel, analogously to the respective first wires 6 and the respective second wires 8. Furthermore, this first conductive shielding 22 and the further conductive shielding 24 are galvanically connected in parallel to a first capacitor 26 and a further capacitor 30. In general, the first capacitor 26 would be sufficient for tuning. However, with the help of the further capacitor 30 the capacitance may be adjusted even finer.

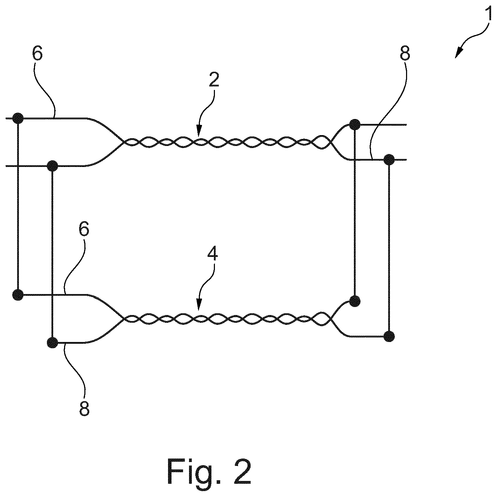

Fig. 2 schematically depicts a radio frequency transmission line 1 according to another preferred embodiment of the invention. While, according to the embodiment of Fig. 1, the first symmetrical transmission line 2 and the further symmetrical transmission line 4 run parallel to each other, here, the first symmetrical transmission line 2 and the further symmetrical transmission line 4 are both formed by a twisted pair. For the sake of clarity, here, the depiction of the shieldings is omitted.

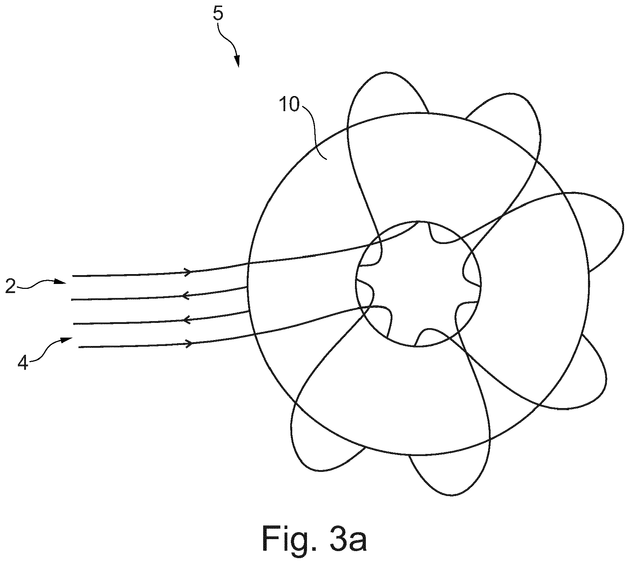

Fig. 3a schematically depicts a radio frequency transmission line arrangement 1 wrapped around a toroid 10 according to a preferred embodiment of the invention. Here, the first symmetrical transmission line 2 and the further symmetrical transmission line 4 are wound around the toroid 10 in opposite directions as indicated by the arrows. For the sake of clarity, the inner conductors (first wires 6 and second wires 8) and the shieldings 22 and 24 are not shown in detail. As depicted in Fig. 1, the trap resonance is adjusted with the capacitor 26 and optionally fine tuning is achieved with a second (parallel) capacitor 30.

Here, there are two winding directions, one referring to the toroid 10 itself (large diameter) and one referring to the cross section of the toroid 10. The winding around the cross section is what makes the small windings of the transmission lines 2, 4. The opposite winding directions are along the toroid 10 itself. With the arrows, the signal direction is denoted. It should be noted that the return line parts of the of the transmission lines 2, 4 cross each other on the back side of the toroid 10 which cannot be depicted in Fig. 3a.

The first symmetrical transmission line 2 goes clockwise around the toroid 10 and the further symmetrical transmission line 4 counterclockwise. In both cases, the winding direction around the cross section is the same, i.e. towards the center at the top side and towards outside at the bottom (hidden in the drawing). That is the same direction to form an inductor for the common mode. The advantage of this opposite winding around the toroid 10 is that there is no net loop around the toroid 10. In this way, a coil 5 is formed. The coil 5 thus formed can be used to form an oscillating circuit that can be used to generate a common mode trap.

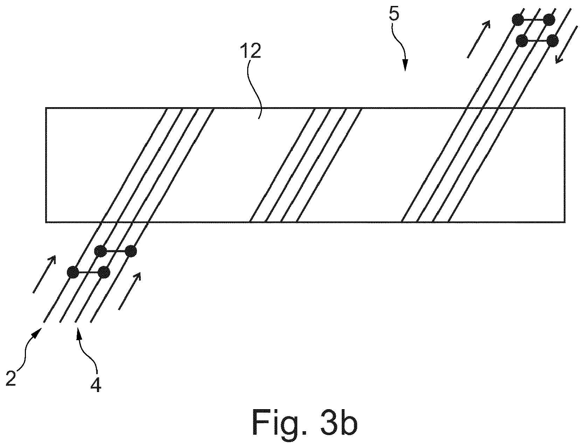

Similar considerations apply to Fig. 3b, which also depicts a radio frequency transmission line arrangement 1 wherein, here, the first symmetrical transmission line 2 and the further symmetrical transmission line 4 are wrapped in the same direction (indicated by arrows) around a solenoid 12 to form another coil 5. The magnetic field generated by this coil 5 is guided longitudinally through the solenoid 12.

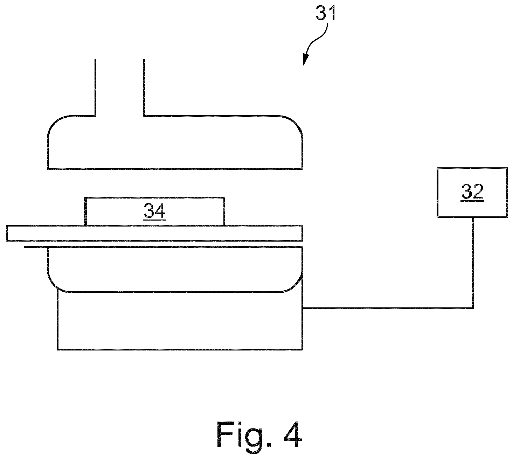

Finally, Fig. 4 schematically depicts a magnetic resonance imaging system 31 with a controller 32 according to a preferred embodiment of the invention. In this magnetic resonance imaging system 31, the radio frequency transmission line arrangement 1 is used for a radio frequency coil 34.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Radio frequency transmission line arrangement | 1 |
| First symmetrical transmission line | 2 |
| Further symmetrical transmission line | 4 |
| Coil | 5 |
| First wire | 6 |
| Second wire | 8 |
| Toroid | 10 |
| Solenoid | 12 |
| First conductive shielding | 22 |
| Further conductive shielding | 24 |
| First capacitor | 26 |
| Further capacitor | 30 |
| Magnetic resonance imaging system | 31 |
| Controller | 32 |
| Radio frequency coil | 34 |

## Claims

1. Radio frequency transmission line arrangement (1) for a magnetic resonance imaging device, comprising a first symmetrical transmission line (2) having a first characteristic impedance and a further symmetrical transmission line (4) having a further characteristic impedance, wherein
the first symmetrical transmission line (2) and the further symmetrical transmission line (4) each comprise a first wire (6) and a second wire (8),
the first wire (6) of the first symmetrical transmission line (2) is galvanically connected in parallel to the first wire (6) of the further symmetrical transmission line (4) and
the second wire (8) of the first symmetrical transmission line (2) is galvanically connected in parallel to the second wire (8) of the further symmetrical transmission line (4) such
that the total characteristic impedance of the radio frequency transmission line arrangement (1) resulting from the first symmetrical transmission line (2) and the further symmetrical transmission line (4) is reduced compared to the first characteristic impedance and the further characteristic impedance, respectively.

2. Radio frequency transmission line arrangement (1) according to claim 1, wherein
the first wire (6) of the first symmetrical transmission line (2) and the second wire (8) of the first symmetrical transmission line (2) are twisted with each other and/or
the first wire (6) of the further symmetrical transmission line (4) and the second wire (8) of the further symmetrical transmission line (4) are twisted with each other and/or
the first symmetrical transmission line (2) and the further symmetrical transmission line (4) are twisted with each other.

3. Radio frequency transmission line arrangement (1) according to claim 1 or 2, wherein the first symmetrical transmission line (2) and the further symmetrical transmission line (4) are wrapped around a body such that a coil (5) is formed.

4. Radio frequency transmission line arrangement (1) according to claim 3, wherein the first symmetrical transmission line (2) and the further symmetrical transmission line (4) are wrapped around the body in opposite directions.

5. Radio frequency transmission line arrangement (1) according to any one of claims 3 and 4, wherein the body is a toroid (10).

6. Radio frequency transmission line arrangement (1) according to any one of claims 3 and 4, wherein the body is a solenoid (12).

7. Radio frequency transmission line arrangement (1) according to any one of the preceding claims, wherein
the first symmetrical transmission line (2) and the further symmetrical transmission line (4) are each formed by a twinaxial cable, the first wire (6) and the second wire (8) of the first symmetrical transmission line (2) and the further symmetrical transmission line (4) being formed by the first inner conductors of the twinaxial cables, and
a ground potential of the radio frequency transmission line arrangement (1) resulting from the first symmetrical transmission line (2) and the further symmetrical transmission line (4) is formed in a first conductive shielding (22) of the first symmetrical transmission line (2) in parallel to a further conductive shielding (24) of the further symmetrical transmission line (4).

8. Radio frequency transmission line arrangement (1) according to any of the preceding claims, wherein the first conductive shielding (22) and the further conductive shielding (24) are galvanically connected in parallel to a first capacitor (26).

9. Radio frequency transmission line arrangement (1) according to any of the preceding claims, wherein multiple further symmetrical transmission lines (4) are provided.

10. Magnetic resonance imaging system (31) with a radio frequency transmission line arrangement (1) according to any of the preceding claims.
